# EUROPÄISCHE PATENTSCHRIFT

(11) **EP 4 283 875 B1**
(45) Veröffentlichungstag und Bekanntmachung des Hinweises auf die Patenterteilung: **20.05.2026**
(21) Anmeldenummer: 22175146.4
(22) Anmeldetag: 24.05.2022
(51) Int. Cl.: H03K 17/18, G05B 19/042, G01R 31/327

(54) **VERFAHREN ZUR ÜBERWACHUNG EINER MEHRZAHL KURZSCHLUSSBILDENDER MELDEELEMENTE UND ANORDNUNG ZUR DURCHFÜHRUNG DES VERFAHRENS**
METHOD FOR MONITORING A PLURALITY OF SHORT CIRCUIT-FORMING SIGNALLING ELEMENTS AND ARRANGEMENT FOR CARRYING OUT THE METHOD
PROCÉDÉ DE SURVEILLANCE D'UNE PLURALITÉ D'ÉLÉMENTS DE SIGNALISATION FORMANT LE COURT-CIRCUIT ET DISPOSITIF DE MISE EN UVRE DU PROCÉDÉ

(43) Veröffentlichungstag der Anmeldung: 29.11.2023
(73) Patentinhaber: Siemens Aktiengesellschaft, 80333 München (DE)
(72) Erfinder: Antoniou, Aristotelis, 155 00 Prague 13 Stodulky (CZ); Gramolla, Tobias, 92245 Kümmersbruck (DE); Kalfoudis, Panagiotis, 158 00 Praha 13 (CZ)
(74) Vertreter: Siemens Patent Attorneys

(56) Entgegenhaltungen:
- EP-A1- 1 480 049
- EP-B1- 2 988 419
- DE-A1- 4 441 070
- US-A1- 2001 024 125
- US-A1- 2011 204 729

## Beschreibung

Die Erfindung betrifft ein Verfahren zur Überwachung kurzschlussbildender Meldeelemente und Anordnung zur Durchführung des Verfahrens.

Meldeelemente wie beispielsweise Schaltmatten oder Not-AusSchalter werden im Rahmen von Sicherheitssteuerungen vor allem im industriellen Bereich dazu verwendet, elektrische Verbraucher wie beispielsweise Pressen oder Fräswerkzeuge sicher ein- und auszuschalten, um Gefahren für Mensch und Material zu verhindern.

Die Sicherheitssteuerungen weisen üblicherweise eine Anzahl von Schalteingängen und -ausgängen zum Anschluss der Arbeitskontakte der Meldeelemente auf.

Neben der Überwachung der Schaltstellung der Meldeelemente ist dabei auch eine ständige Funktionsüberprüfung der Sicherheitssteuerung erforderlich, um die relevanten Sicherheitsnormen-und zertifizierungen zu erfüllen. Für besonders hohe Sicherheitsstufen umfasst dies insbesondere auch eine ständige Prüfung der Verkabelung der angeschlossenen Meldeelemente.

Diese Prüfung erfolgt üblicherweise durch Austastlücken in den logischen Signalen an den Schaltausgängen. Bei üblichen digitalen Logiken liegt an den Schaltausgängen entweder eine logische 1 oder eine logische 0 an, die durch bestimmte Spannungswerte unterschieden werden. So wird typisch eine Spannung von +24 V der logischen 1 zugeordnet, während das Erdungspotential die logische 0 darstellt.

Um zu erkennen, ob die an den Schalteingängen der Sicherheitssteuerung anliegende Spannung tatsächlich auch mit der Ausgangsspannung der Sicherheitssteuerung übereinstimmt, wird die Ausgangsspannung mit regelmäßigen Austastlücken versehen.

Im Fall eines Kabelfehlers, mit beispielsweise einem Querschluss zu einem anderen Kabel mit entsprechender Spannung, ist diese Austastlücke am Schalteingang nicht mehr feststellbar und der Fehler erkennbar.

Dieses Prinzip wird neben der Querschlusserkennung häufig auch zur Ermittlung des Schaltzustands sogenannter kurzschlussbildender Meldeelemente verwendet. Diese Meldeelemente weisen zwei Strompfade mit jeweils einem Eingang und einem Ausgang auf, die bei Betätigung kurzgeschlossen werden.

Zur Ermittlung des Schaltzustands eines Meldeelementes werden sowohl der erste Eingang als auch der zweite Eingang des Meldeelementes mit einem mit Austastlücken versehenen Spannungssignal beaufschlagt. Die Austastlücken sind dabei jedoch zeitlich versetzt, so dass die Austastlücken in den beiden Strompfaden immer zu unterschiedlichen Zeiten auftreten. Wird das Meldeelement betätigt und somit die Strompfade kurzgeschlossen, werden - ebenso wie bei einem Querschluss - die Austastlücken überbrückt. Sie sind daher an den Ausgängen der Strompfade, die an die Schalteingänge der Sicherheitssteuerung angeschlossen sind, nicht mehr feststellbar und die Sicherheitssteuerung kann die Betätigung des Meldeelements erkennen.

Da die Erkennung der Betätigung durch den Vergleich von Eingangs- und Ausgangssignal erfolgt, und bei Betätigung des Meldeelements ein Unterschied nur während einer Austastlücke auftritt, ist die Erfassungsgenauigkeit durch die Frequenz der Austastlücken begrenzt. Es ergibt sich somit stets ein Versatz zwischen tatsächlicher Betätigung und Erfassung und eine sehr kurze Betätigung des Meldeelements wird sogar überhaupt nicht erfasst, wenn sie zwischen zwei Austastlücken erfolgt. Zudem erfordert das System hinsichtlich der Signalauswertung stets die Kenntnis der genauen Position der Austastlücken.

Nach der Lehre der EP 2 988 419 B1 wird daher vorgeschlagen, die beiden Eingänge des Meldeelementes mit um 180 ⁰ phasenverschobenen symmetrischen Rechtecksignalen zu beaufschlagen, bei denen Austastlücken und Einschaltdauer gleich lang sind.

Damit kann bei einem einzelnen Meldeelement mittels einfacher Entweder-Oder-Auswertung eine besonders einfache und sichere Erkennung des Betätigungszustands des Meldeelements erreicht werden.

Beim Einsatz einer Mehrzahl von Meldeelementen sind diese nach dem Stand der Technik üblicherweise seriell geschaltet, wodurch eine Auswertung nur für die Gesamtheit der Meldeelemente möglich ist und keine Identifikation einzelner Elemente erfolgt.

Aus der Druckschrift US 2011/204729 A1 ist eine Sicherheitsschalteinrichtung zur ausfallsicheren Ansteuerung von Stellgliedern sowie eine Notabschaltung mit einer Sicherheitsschalteinrichtung bekannt. Die Sicherheitsschalteinrichtung umfasst mindestens einen ersten und zweiten Sicherheitseingang zur Aufnahme eines ersten und zweiten Eingangssignals, mindestens einen ersten und zweiten Sicherheitsausgang zur Abgabe eines ersten und zweiten Ausgangssignals und eine Steuereinheit zur Auswertung der Eingangssignale und zur Erzeugung der Ausgangssignale. Der erste und der zweite Sicherheitsausgang umfassen ferner eine Rückkopplungsschleife, die die Ausgangssignale an die Steuereinheit zurückkoppelt, so dass die Steuereinheit in der Lage ist, eine Testroutine zum Testen der Ausgangssignale durchzuführen.

Aus der Druckschrift DE 44 41 070 A1 ist eine Sicherheitsschalteranordnung zum Ein- und Ausschalten der Stromversorgung eines Arbeitsmittels mittels eines Sensorsignals bekannt, welches dem Arbeitsmittel über zwei Auswertekanäle mit jeweils einem Aktor zugeführt wird, wobei die Aktoren aus Halbleiterelementen bestehende schalterartige Mittel aufweisen, jedem Aktor eine Rechnereinheit vorgeschaltet ist, die mit dem Aktor über zwei bidirektionale Zuleitungen verbunden ist, wobei über die erste Zuleitung rücklesbar Schaltimpulse von der Rechnereinheit zum Aktor übertragen werden und dort einen Schaltvorgang auslösen, und wobei über die zweite Zuleitung rücklesbar Testimpulse von der Rechnereinheit zum Aktor zu dessen Funktionsüberprüfung übertragen werden, die Rechnereinheiten über eine bidirektionale Zuleitung zu deren Funktionsüberprüfung verbunden sind, und von den Rechnereinheiten zur Funktionsüberprüfung der Aktoren die Schaltzustände der schalterartigen Mittel so kurzzeitig geändert werden, dass sich der Betriebszustand des Arbeitsmittels aufgrund seiner Trägheit nicht ändert.

Der Erfindung liegt die Aufgabe zugrunde, den bekannten Stand der Technik so zu erweitern, dass eine einfache Auswertung des Betätigungszustandes und die Erkennung von Kabelfehlernbei mehreren Meldeelementen möglich ist.

Erfindungsgemäß geschieht dies mit einem Verfahren gemäß Anspruch 1. Vorteilhafte Ausgestaltungen ergeben sich aus den Unteransprüchen.

Die Erfindung wird anhand von Figuren näher erläutert.

Es zeigen beispielhaft:
Fig 1 eine schematische Darstellung einer Sicherheitssteuerung mit einer angeschlossenen Trittmatte, und
FIG 2 eine graphische Darstellung der verschiedenen Schaltsignale an Schaltausgängen der Sicherheitssteuerung.

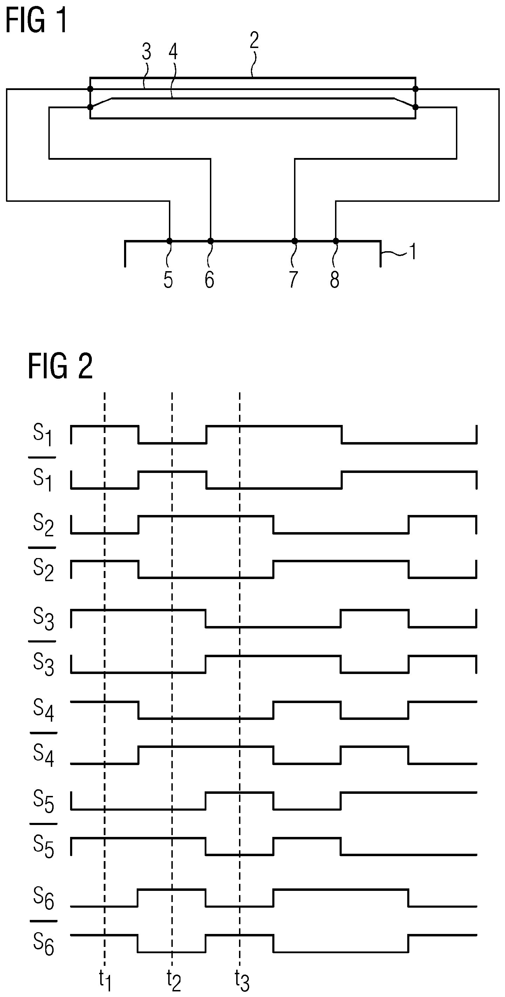

Die Darstellung gemäß FIG 1 zeigt eine Sicherheitssteuerung 1 mit einer nicht dargestellten Steuereinheit, welche beispielsweise als Mikrocontroller ausgestaltet sein kann.

Die Sicherheitssteuerung 1 hat zwei Schaltausgänge 4,
die in die Stromzufuhr eines elektrischen Verbrauchers eingefügt sind, der im Gefahrenfall sicher ausgeschaltet werden soll.

Als kurzschlussbildendes Meldeelement ist eine Trittmatte 2 vorgesehen, welche zwei parallele Strompfade 3,4 aufweist. Die Eingänge der Strompfade 3, 4 sind mit Schaltausgängen 5,6 der Sicherheitssteuerung 1 und die Ausgänge der Strompfade mit Schalteingängen 7,8 der Sicherheitssteuerung verbunden.

Die Trittmatten 2 dienen der Absicherung größerer Flächen. Sie werden in gefährlichen Arbeitsbereichen elektrischer Verbraucher auf dem Boden ausgelegt. Wird eine Trittmatte 2 betreten, erfolgt ein Kurzschluss zwischen den beiden Strompfaden 3,4.

Dieser Kurzschluss wird durch Überwachung der entsprechenden Signaleingänge 7,8 durch die Sicherheitseinrichtung 1 erkannt und der Verbraucher ausgeschaltet.

Gemäß den gesetzlichen Bestimmungen ist aber nicht nur die Auslösung der Matten, sondern die ordnungsgemäße Funktion der Meldeelemente zu überwachen. Es könnten ja beispielsweise durch einen Drahtbruch oder einen Kurzschluss in den Zuleitungen der Strompfade Fehler auftreten.

Erfindungsgemäß werden dazu beim Einsatz mehrerer Trittmatten die Strompfade derselben mit unterschiedlichen Signalfolgen S₁...Sₙ, *S̅*₁...*S̅*ₙ in der Weise beaufschlagt, dass innerhalb eines vorgegebenen Zeitrahmens zu jedem Zeitpunkt eine einfach dekodierbare, eindeutige, binäre Darstellung des Zustandes der angeschlossenen Trittmatten 2 vorliegt. Dabei wird der jeweils zweite der beiden Strompfade 4 eines Meldeelements mit der invertierten Signalfolge *S̅*_{1...}*S̅*ₙ des jeweils ersten Strompfades 3 beaufschlagt.

Fig. 2 zeigt die Schaltsignale an 12 unterschiedlichen Schaltausgängen 5,6 der Sicherheitssteuerung 1 für den Anschluss an die jeweils zwei parallelen Strompfade von 6 Trittmatten 2. Im Zeitpunkt t1 dieser Darstellung ist beispielsweise der (sichere) Zustand der Trittmatten 2 durch die binäre Zahl 10 01 10 10 01 01 definiert.

Insgesamt zeigen im dekodierten Zeitrahmen 6 unterschiedliche Binärzahlen den sicheren Zustand der 6 Trittmatten an.

Eine Abweichung davon weist auf das Vorliegen eines Auslösevorganges hin. So ist beispielsweise die binäre Zahl **11** 01 10 10 01 01 ein Hinweis darauf, dass Trittmatte Nr. 1 zum Zeitpunkt t1 betreten wurde und ein Kurzschluss zwischen den beiden Strompfaden 3,4 dieser Trittmatte aufgetreten ist.

Allerdings ist diese Aussage nicht eindeutig, da in einem Fehlerfall auch beispielsweise ein Kurzschluss zwischen der Zuleitung zum zweiten Strompfad der ersten Matte und der Zuleitung zum ersten Stromkreis der dritten Matte zu einer entsprechenden Binärzahl **11** 01 10 10 01 01 hin.

Für die Unterscheidung, ob ein Auslösevorgang oder ein Fehler vorliegt, ist daher die Betrachtung mehrerer aufeinanderfolgender Zeitpunkte t₁, t₂, t₃ im Signalverlauf erforderlich.

So wären die Signalwerte ***S̅***₁ und S₃ bei einer Auslösung durch ein Betreten der ersten Matte zu den drei Zeitpunkten (**11**, **11**, **11**) also durchgehend 11, während der Kurzschluss zwischen der Zuleitung zum zweiten Strompfad der ersten Matte und der Zuleitung zum ersten Stromkreis der dritten Matte die Signalwerte ***S***₁ und S₃ (11, 11, 00) zu den drei Zeitpunkten ergibt.

Für eine rasche Ermittlung der Ursache sind die Schaltsignale *S̅*₁...*S̅*ₙ wie aus Figur 2 ersichtlich aufzubauen. Jedes Signal weist periodisch wiederkehrend eine Abfolge von einem kurzen Impuls und einer kurzen Austastlücke sowie einem langen Impuls und einer langen Austastlücke auf, wobei Impulse und Austastlücken jeweils die gleiche Dauer aufweisen und die langen Impulse bzw. Austastlücken die doppelte Dauer der kurzen Impulse bzw. Austastlücken aufweisen.

Die einer einzelnen Matte zuzuordnenden Schaltsignale S₁ und *S̅*₁ weisen eine übereinstimmende Phasenlage auf, die Signale der unterschiedlichen Matten sind zueinander phasenverschoben, die Dauer der Verschiebung zwischen 2 benachbarten Signalen also beispielsweise zwischen S₁ und S₂ oder S₂ und S₃ ... entspricht im vorliegenden Fall mit 6 Matten der Dauer eines schmalen Impulses, bzw. einem Sechstel der Periodendauer des Signales, und somit einer Phasenverschiebung von 60°, d.h. 360°/n mit n = Anzahl der Matten, im vorliegenden Fall sechs Stück.

Der vorliegende Signalaufbau eignet sich zur Ansteuerung von bis zu 6 Matten, bei einer größeren Anzahl besteht beispielsweise die Möglichkeit die Signale um einen zweiten kurzen Impuls mit Austastlücke zu erweitern.

Es wäre auch denkbar das Basissignal mit einem Kurzen und einem langen Impuls plus Austastlücken zu belassen, aber die Phasenverschiebung bzw. die Dauer der Verschiebung zwischen 2 benachbarten Signalen auf die Hälfte eines schmalen Impulses zu reduzieren.

### Bezugszeichenliste

- 1: Sicherheitssteuerung
- 2: Trittmatte
- 3: erster Strompfad
- 4: zweiter Strompfad
- 5,6: Schaltausgänge der
- 7,8: Schalteingänge der Sicherheitssteuerung
- S₁...Sₙ: Signalfolge am ersten Strompfad der ersten bis n^{ten} Trittmatte
- *S̅*₁...*S̅*ₙ: Signalfolge am zweiten Strompfad der ersten bis n^{ten} Trittmatte

- t₁, t₂, t₃: Zeitpunkte im Signalverlauf

## Patentansprüche

1. Verfahren zur Überwachung einer Mehrzahl kurzschlussbildender Meldeelemente, wobei jedes Meldeelement zumindest zwei Strompfade aufweist, die bei Betätigung des Meldeelements kurzgeschlossen werden, und die Meldeelemente als Trittmatten (2) ausgebildet sind, **dadurch gekennzeichnet, dass** die Strompfade (3,4) der Meldeelemente (2) mit unterschiedlichen Signalfolgen (S₁...S_{n,} *S̅*₁...*S̅*ₙ) in der Weise beaufschlagt werden, dass innerhalb eines vorgegebenen Zeitrahmens zu jedem Zeitpunkt eine einfach dekodierbare, eindeutige, binäre Darstellung des Zustandes der angeschlossenen Trittmatten (2) vorliegt und dass das Betreten der Trittmatten von einem Fehler in den Zuleitungen zu den Strompfaden unterschieden werden kann, indem eine Betrachtung mehrerer aufeinanderfolgender Zeitpunkte (t1, t2, t3) im Signalverlauf durchgeführt wird und eine Abweichung in den Schaltsignalen an den Schaltausgängen (5, 6) der Strompfade (3, 4) einem Vorliegen eines Auslösevorgangs oder einem Fehlerfall zugeordnet wird.

2. Verfahren nach Anspruch 1, **dadurch gekennzeichnet, dass** der jeweils zweite (4) der beiden Strompfade eines Meldeelements (2) mit der invertierten Signalfolge (*S̅*₁...*S̅*ₙ) des jeweils ersten Strompfades beaufschlagt wird.

3. Verfahren nach Anspruch 1 oder 2, **dadurch gekennzeichnet, dass** jedes Signal eine periodisch wiederkehrende Abfolge von einem kurzen Impuls und einer kurzen Austastlücke sowie einem langen Impuls und einer langen Austastlücke aufweist, dass Impulse und Austastlücken jeweils die gleiche Dauer aufweisen und die langen Impulse bzw. Austastlücken die doppelte Dauer der kurzen Impulse bzw. Austastlücken aufweisen, und dass die einer einzelnen Matte zuzuordnenden Schaltsignale eine übereinstimmende Phasenlage aufweisen und die Signale der unterschiedlichen Matten um 60° zueinander phasenverschoben sind.

4. Verfahren nach Anspruch 1 oder 2, **dadurch gekennzeichnet, dass** jedes Signal eine periodisch wiederkehrende Abfolge von einem kurzen Impuls und einer kurzen Austastlücke sowie einem langen Impuls und einer langen Austastlücke aufweist, dass Impulse und Austastlücken jeweils die gleiche Dauer aufweisen und die langen Impulse bzw. Austastlücken die doppelte Dauer der kurzen Impulse bzw. Austastlücken aufweisen, und dass die einer einzelnen Matte zuzuordnenden Schaltsignale eine übereinstimmende Phasenlage auf weisen und die Signale der unterschiedlichen Matten um 360°^{/}n mit n gleich der Anzahl der Matten zueinander phasenverschoben sind.

5. Verfahren nach Anspruch 1 oder 2, **dadurch gekennzeichnet, dass** jedes Signal eine periodisch wiederkehrende Abfolge von zwei kurzen Impulsen und kurzen Austastlücke sowie einem langen Impuls und einer langen Austastlücke aufweist, dass Impulse und Austastlücken jeweils die gleiche Dauer aufweisen und die langen Impulse bzw. Austastlücken die doppelte Dauer der kurzen Impulse bzw. Austastlücken aufweisen, und dass die einer einzelnen Matte zuzuordnenden Schaltsignale eine übereinstimmende Phasenlage auf weisen und die Signale der unterschiedlichen Matten um 40° zueinander phasenverschoben sind.

6. Verfahren nach Anspruch 1, **dadurch gekennzeichnet, dass** als Meldeelemente Trittmatten (2) vorgesehen sind, die derart ausgebildet ist, dass bei einem Betreten der Trittmatte (2) ein Kurzschluss zwischen den beiden Strompfaden (3,4) verursacht wird.

7. Anordnung zur Durchführung des Verfahrens nach einem der Ansprüche 1 bis 3, **dadurch gekennzeichnet, dass** eine Sicherheitssteuerung (1) vorgesehen ist, welche eine Mehrzahl von Signalausgängen (5,6) und Signaleingängen (7,8) umfasst, und dass kurzschlussbildende Meldeelemente (2) vorgesehen sind, welche jeweils zumindest zwei Strompfade (3,4) aufweisen, die bei Betätigung des Meldeelements (2)kurzgeschlossen werden und die mit Signalausgängen und Signaleingängen der Sicherheitssteuerung verbunden sind und eine Abweichung in den Schaltsignalen an den Schaltausgängen (5, 6) der Strompfade (3, 4) einem Vorliegen eines Auslösevorgangs oder einem Fehlerfall zuordenbar ist.

## Claims

1. Method for monitoring a plurality of short-circuit forming indicating elements, wherein each indicating element has at least two current paths, which are short-circuited upon actuation of the indicating element, **characterised in that** the current paths (3,4) of the indicating elements (2) are supplied with different signal sequences (S₁...S_{n,} *S̅*₁...*S̅*ₙ) in such a way that a simple, decodable, unique, binary representation of the state of the connected pressure sensitive mats (2) exists at each time instant within a predetermined time frame and that it is possible to differentiate a stepping on the pressure sensitive mat from an error in the supply lines to the current paths by several consecutive time instants (t₁, t₂, t₃) in the signal curve being observed and a deviation in the switching signals at the switching outputs (5, 6) of the current paths (3, 4) being assigned to the presence of a tripping operation or a fault.

2. Method according to claim 1, **characterised in that** the respective second (4) of the two current paths of an indicating element (2) is supplied with the inverted signal sequence ( *S̅*₁...*S̅*ₙ) of the respective first current path.

3. Method according to claim 1 or 2, **characterised in that** each signal has a periodically recurring sequence of a short impulse and a short blanking interval and a long impulse and a long blanking interval, that impulses and blanking intervals have the same duration in each case and the long impulse or blanking intervals have twice the duration of the short impulse or blanking intervals, and that the switching signals to be assigned to an individual mat have a concurring phase position and the signals of the different mats are phase shifted by 60° with respect to one another.

4. Method according to claim 1 or 2, **characterised in that** each signal has a periodically recurring sequence of a short impulse and a short blanking interval and a long impulse and a long blanking interval, that impulses and blanking intervals have the same duration in each case and the long impulses or blanking intervals have twice the duration of the short impulse or blanking intervals, and that the switching signals to be assigned to an individual mat have a concurring phase position and the signals of the different mats are phase shifted by 360°/n with respect to one another with n equating to the number of mats.

5. Method according to claim 1 or 2, **characterised in that** each signal has a periodically recurring sequence of two short impulses and a short blanking interval and a long impulse and a long blanking interval, that impulses and blanking intervals have the same duration in each case and the long impulse or blanking intervals have twice the duration of the short impulses or blanking intervals, and that the switching signals to be assigned to an individual mat have a concurring phase position and the signals of the different mats are phase shifted by 40° with respect to one another.

6. Method according to claim 1, **characterised in that** pressure sensitive mats (2) are provided as indicating elements, which is embodied so that a short circuit between the two current paths (3,4) is caused when the pressure sensitive mat (2) is stepped on.

7. Arrangement for carrying out the method according to one of claims 1 to 3, **characterised in that** a safety controller (1) is provided, which comprises a plurality of signal outputs (5,6) and signal inputs (7,8) and that short-circuit forming indicating elements (2) are provided, which each have at least two current paths (3,4), which are short-circuited upon actuation of the indicating element (2) and which are connected to signal outputs and signal inputs of the safety controller and a deviation in the switching signals at the switching outputs (5, 6) of the current paths (3, 4) can be assigned to the presence of a tripping operation or a fault.

## Revendications

1. Procédé de surveillance d'une pluralité d'éléments de signalisation formant le court-circuit, dans lequel chaque élément de signalisation comporte au moins deux chemins de courant qui sont court-circuités lors de l'actionnement de l'élément de signalisation, et dans lequel les éléments de signalisation sont mis en œuvre sous forme de tapis (2), **caractérisé en ce que** les chemins de courant (3, 4) des éléments de signalisation (2) sont alimentés avec différentes séquences de signaux (S₁...S_{n,} S̅₁... S̅ₙ) de telle sorte qu'une représentation binaire univoque et facilement décodable de l'état des tapis connectés (2) soit disponible à tout moment dans un intervalle de temps prédéfini et que le fait de marcher sur les tapis puisse être distingué d'un défaut dans les lignes d'alimentation vers les chemins de courant; pour ce faire, une prise en compte de plusieurs moments successifs (t1, t2, t3) est effectuée dans le déroulement du signal et un écart dans les signaux de commutation aux sorties de commutation (5, 6) des chemins de courant (3, 4) est attribué à la présence d'un processus de déclenchement ou d'un défaut.

2. Procédé selon la revendication 1, **caractérisé en ce que** le deuxième chemin de courant (4) parmi les deux chemins de courant d'un élément de signalisation (2) est alimenté par la séquence de signaux inversée (S̅₁... S̅ₙ) du premier chemin de courant.

3. Procédé selon la revendication 1 ou la revendication 2, **caractérisé en ce que** chaque signal présente une séquence périodique répétitive composée d'une impulsion courte et d'un intervalle de suppression court ainsi que d'une impulsion longue et d'un intervalle de suppression long, **en ce que** les impulsions et les intervalles de suppression ont chacun la même durée et **en ce que** les impulsions longues respectivement les intervalles de suppression longs ont deux fois la durée de celle des impulsions courtes respectivement des intervalles de suppression courts, et **en ce que** les signaux de commutation attribués à un seul tapis présentent une position de phase correspondante et **en ce que** les signaux des différents tapis sont déphasés de 60° les uns par rapport aux autres.

4. Procédé selon la revendication 1 ou la revendication 2, **caractérisé en ce que** chaque signal présente une séquence périodique répétitive composée d'une impulsion courte et d'un intervalle de suppression court ainsi que d'une impulsion longue et d'un intervalle de suppression long, **en ce que** les impulsions et les intervalles de suppression ont chacun la même durée et **en ce que** les impulsions longues respectivement les intervalles de suppression longs ont deux fois la durée de celle des impulsions courtes respectivement des intervalles de suppression courts, et **en ce que** les signaux de commutation attribués à un seul tapis présentent une position de phase correspondante et **en ce que** les signaux des différents tapis sont déphasés de 360°/n les uns par rapport aux autres, avec n qui équivaut au nombre de tapis.

5. Procédé selon la revendication 1 ou la revendication 2, **caractérisé en ce que** chaque signal présente une séquence périodique répétitive composée de deux impulsions courtes et de deux intervalles de suppression courts ainsi que d'une impulsion longue et d'un intervalle de suppression long, **en ce que** les impulsions et les intervalles de suppression ont chacun la même durée et **en ce que** les impulsions longues respectivement les intervalles de suppression longs ont deux fois la durée de celle des impulsions courtes respectivement des intervalles de suppression courts, et **en ce que** les signaux de commutation attribués à un seul tapis présentent une position de phase correspondante et **en ce que** les signaux des différents tapis sont déphasés de 40° les uns par rapport aux autres.

6. Procédé selon la revendication 1, **caractérisé en ce que** des tapis de signalisation (2) sont prévus comme éléments de signalisation, lesquels sont conçus de telle sorte que, lorsqu'on marche sur le tapis de signalisation (2), un court-circuit est provoqué entre les deux circuits électriques (3, 4).

7. Agencement pour la mise en œuvre du procédé selon l'une des revendications 1 à 3, **caractérisé en ce qu**'un système de commande de sécurité (1) est prévu, qui comprend une pluralité de sorties de signal (5, 6) et d'entrées de signal (7, 8), et en ce que des éléments de signalisation formant le court-circuit (2) sont prévus, lesquels présentent chacun au moins deux chemins de courant (3, 4) qui sont court-circuités lors de l'actionnement de l'élément de signalisation (2) et qui sont reliés à des sorties de signal et à des entrées de signal de la commande de sécurité et en ce qu'un écart dans les signaux de commutation aux sorties de commutation (5, 6) des chemins de courant (3, 4) peut être attribué à la présence d'un processus de déclenchement ou d'un défaut.
